# EUROPEAN PATENT APPLICATION

(11) **EP 1 631 131 A2**
(43) Date of publication of application: **01.03.2006**
(21) Application number: 05018487.8
(22) Date of filing: 25.08.2005
(51) Int. Cl.: H05K 1/03

(54) **Transmission circuit board structure, transmission circuit board, and connector having the same**

(30) Priority: 31.08.2004 JP 2004251396
(71) Applicant: HIROSE ELECTRIC CO., LTD., Shinagawa-ku Tokyo (JP)
(72) Inventor: Matsuo, Tsutomu c/o Hirose Electric Co., Ltd., Tokyo (JP); Nagata, Masakazu c/o Hirose Electric Co., Ltd., Tokyo (JP)
(74) Representative: Pätzold, Herbert

(57) **Abstract**

A transmission circuit board structure comprises at least one signal layer formed by a plurality of signal lines (20) arranged side by side, at least one ground layer formed of a ground plate (30) and provided in parallel to the signal layer, and a support member (10) made of a dielectric material, formed integrally with the signal lines to support the signal lines. The support member (10) has at least one connection member (12), which abuts against the ground plate (30) at a position where the insulation layer made by an air space is produced between the signal lines (20) and the ground plate (30).

## Description

This invention relates to a transmission circuit board structure, a transmission circuit board, and a connector having the same.

In a high speed transmission, such as a 3 giga (3G) transmission or a transmission beyond 3 giga, a conductor (resistance) loss of a signal line forming a transmission line and a dielectric loss by a dielectric material around the signal line become too large to disregard. Therefore, the structure around the signal line is required to be improved. In a high speed transmission connector having a long transmission path, a transmission circuit board and an insert are used to minimize these losses. For example, the employment of the insert is disclosed in Patent Documents 1 and 2.

In Patent Document 1 and 2, as shown in Figs. 9 and 10, a pair of signal lines 53 and 54 is provided in a dielectric layer 52 covered by a ground plate 51. Patent Document 1 discloses that a pair of the signal lines 53 and 54 is arranged at an interval in a direction of a plane of the circuit board, while Patent Document 2 discloses that they are arranged at an interval in a direction of thickness of the circuit board. When the pair of the signal lines is used as a differential pair, the application disclosed in Patent Document 2 is desirable.

PATENT DOCUMENT 1: Japanese Patent Application Kokai Number 2001-510627.

PATENT DOCUMENT 2: Japanese Patent Application Kokai Number 2004-87348.

In Patent Documents 1 and 2, however, a resin is used, as an insert material, around the signal lines. Since the dielectric rate (ε r) and dielectric loss (tan δ) are large, the transmission degradation (attenuation) is produced. This problem is an obstacle to the high speed transmission, especially the transmission employing the differential pair and, therefore, must be solved.

Therefore, one of the objectives of the present invention is to provide a transmission circuit board structure that solves the above problem, a circuit board having such a structure, and a connector having such circuit boards.

The above object is achieved by the invention as recited in claim 1.

Embodiments of the invention will now be described by way of example with respect to the accompanying drawings in which:
Fig. 1 is a perspective view, partially broken away, of a transmission circuit board structure according to the first embodiment of the present invention;
Fig. 2 is a sectional view of the transmission circuit board structure taken along the line II-II in Fig. 2;
Fig. 3 is a sectional view similar to Fig. 2, but of a variation of the transmission circuit board structure according to the first embodiment;
Fig. 4 is a perspective view, partially broken away, of a transmission circuit board structure according to the second embodiment of the present invention;
Fig. 5 is a sectional view of a variation of the transmission circuit board structure according to the second embodiment;
Fig. 6 is a perspective view of a transmission circuit board structure according to the third embodiment of the present invention;
Fig. 7 is an exploded perspective view, before assembly, of a transmission circuit board according to the fourth embodiment of the present invention;
Fig. 8 is a perspective view of the transmission circuit board of Fig. 7 after assembled;

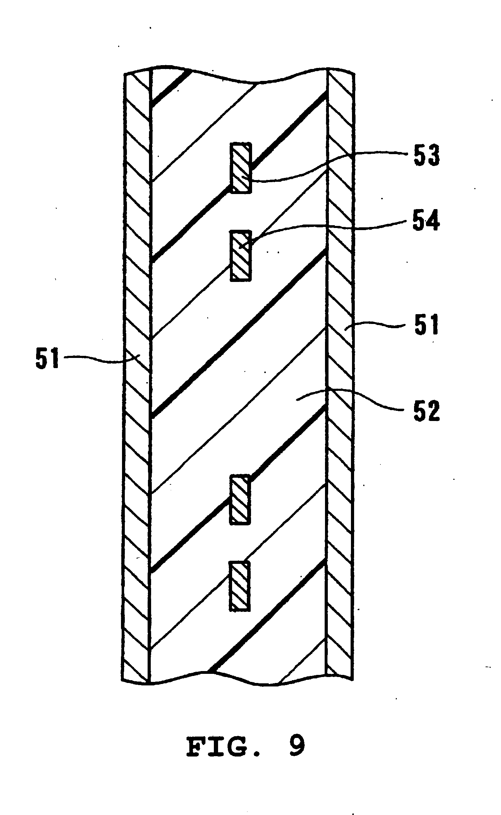

Fig. 9 is a sectional view of a conventional transmission circuit board structure; and

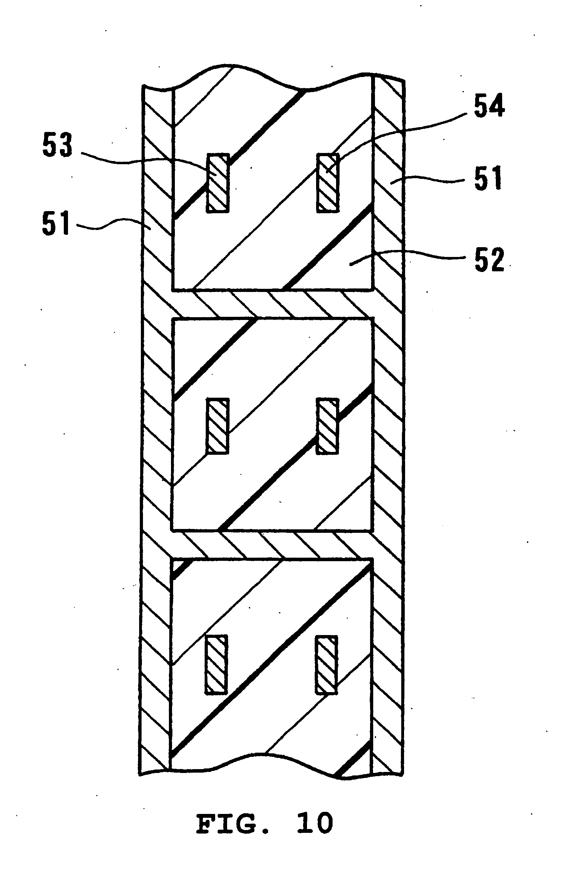

Fig. 10 is a sectional view of another conventional transmission circuit board structure.

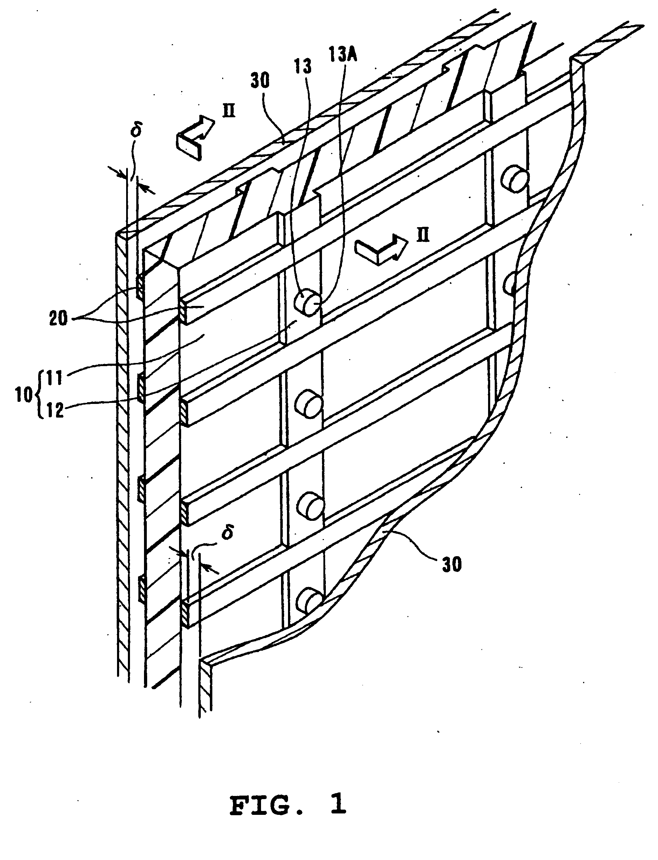

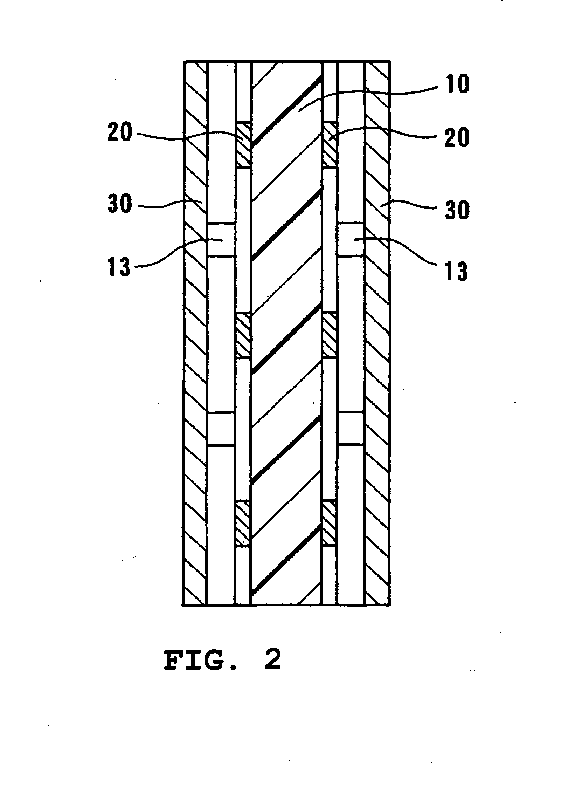

In Figs. 1 and 2, a transmission circuit board structure according to the present invention comprises a support member 10 made of a dielectric material, such as a synthetic resin, signal lines 20 supported by the support member 10 and forming signal layers, and ground palates 30 working as ground layers. The support member 10 comprises a plate member 11 and a plurality of connection members 12, both of which are integrally formed. However, the plate and connection members 11 and 12 may be separately made and then integrated when necessary.

The connection members 12 are a plurality of protrusions, which are provided on both sides of the plate member 11 at a certain interval and extend in parallel to each other in a vertical direction or a longitudinal direction of the plate member 11. A plurality of projections 13 are integrally formed on the respective connection members 12 at a certain interval in the longitudinal direction of the connection members 12. Each of the projections 13 is cylindrical and has a height of δ. The top side of the projection 13 is flat and used as a abutting face 13A, which abuts against the ground plate 30. That is, all the abutting faces 13A of the projections 13 provided on the respective connection members 12 on both the sides of the support member 10 are flush with each other.

The signal lines 20 are held on both sides of the plate member 11 at the same locations viewed in a thichknesswise direction of the plate member 11. Namely, the signal lines form two layers. The respective signal lines 20 are stripes or elongated pieces made of a sheet metal and extend in a horizontal direction (a direction perpendicular to the direction where the connection members 12 extend) between the respective adjacent projections 13. The signal lines 20 cross the respective connection members 12 between the adjacent projections 13 and are flush with the connections members 12 at the crossing points. Accordingly, the projections 13 project from the flush level by a height of δ. It is preferable that the signal lines 20 are integrally formed with the support member 10 with the connection members 12. The abutting faces 13A of the projections 13 are located above the level, by a height of δ, which includes the face of the signal lines 20 and the face of the connection members 12 at the crossing points.

The ground plates 30 made of a flat sheet metal with an appropriate dimension are fixed to both sides of the support member 10. The inside surfaces of the ground plates 30 are brought into contact with the abutting faces 13A of the projections 13 and maintain a constant distance from the signal lines 20, that is, a distance δ equal to the height δ of the projections 13. Consequently, the signal lines 20 are everywhere spaced from the ground plates 30 by the distance δ. Thus, since an air layer is produced between the respective signal lines 20 and the ground plates 30, the dielectric rate (εr) thereof is approximately 1 and dielectric loss (tan δ) thereof is approximately 0.

Such a transmission circuit board as has a structure where the air layer exists between the signal lines 20 and the ground plates 30, is suitable for the high speed transmission. Especially, in the embodiment shown in Figs. 1 and 2, since a pair of the signal lines 20 located at corresponding positions on both the sides of the support member 10 are placed at the same position when viewed from the thicknesswise direction of the board, the pair is preferably used as a differential pair.

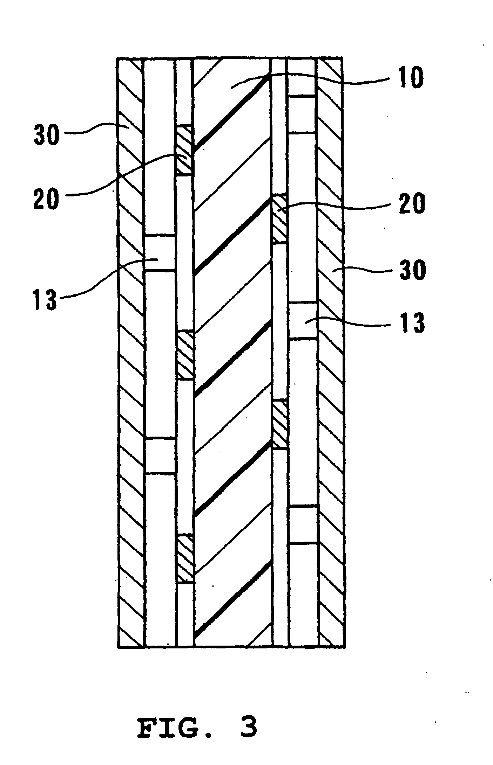

In Fig. 2, since the respective corresponding signal lines 20 are located at the same position in the vertical direction, the embodiment shown in Fig. 2 is preferable when used as a differential pair. In Fig. 3, since the respective corresponding signal lines 20, for example, the uppermost signal lines 20 on both the sides, are slightly offset or shifted from each pother in the vertical direction, the embodiment shown in Fig. 3 is applicable as a single-end line where no cross-talk is produced.

### Second Embodiment:

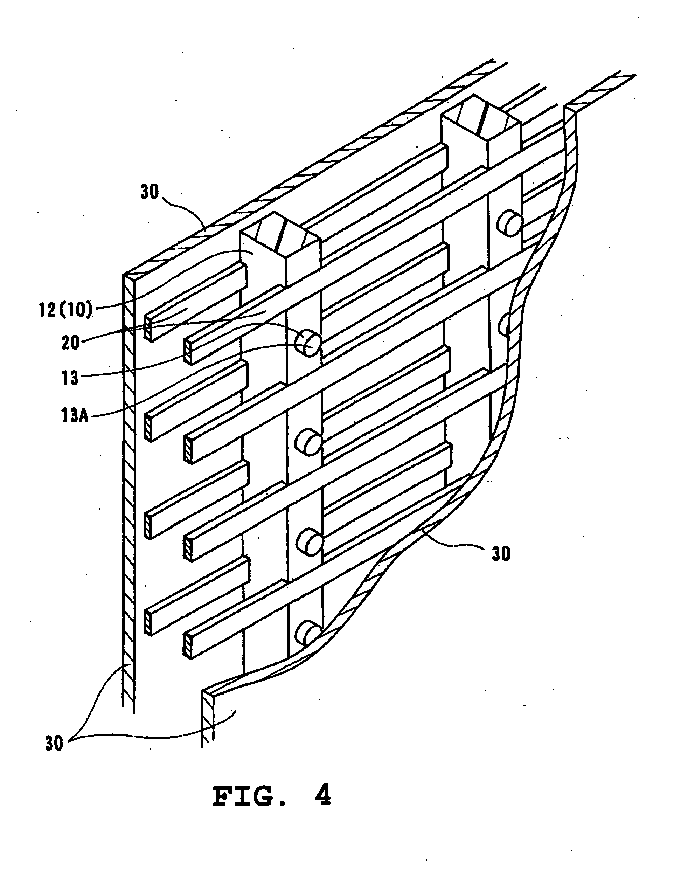

In Fig. 4, the support member 10 is composed of only the connection members 12, which extends in the vertical direction, and includes no plate members 11. The connection members 12 are made of a synthetic resin and have the projections 13 with abutting faces 13A in the same way as in the first embodiment. Accordingly, there is provided an air layer between the signal lines 20 and the ground plates 30.

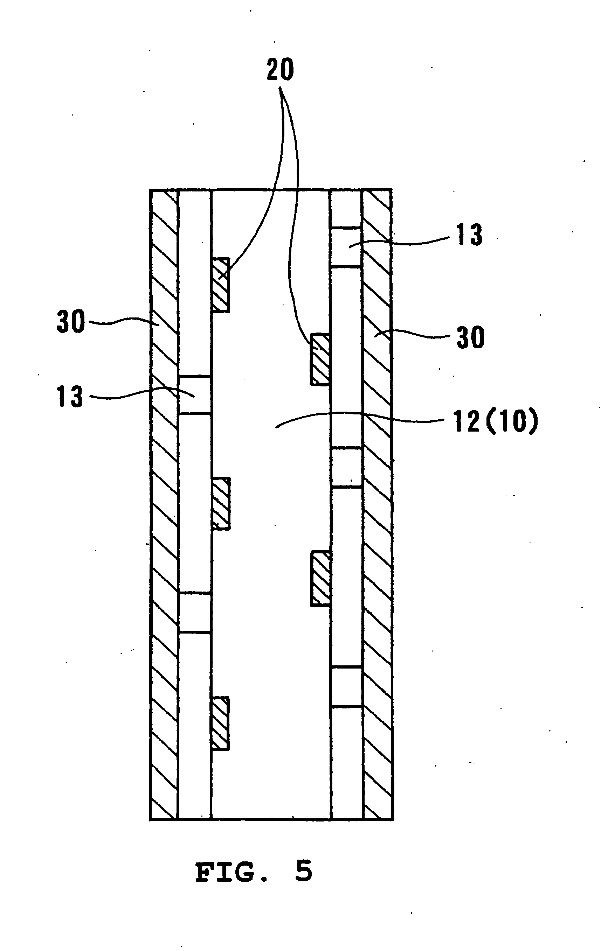

In the second embodiment, too, the signal lines 20 form two layers. The air layer exists not only between the signal layer and the ground plate but also between the two signal layers except for the area where connection members 12 exist. Accordingly, the dielectric rate (ε r) becomes closer to 1 and the dielectric loss (tan δ) approach to 0 infinitely. This effect increases when the connection members are made slimmer and the adjacent connection members 12 are spaced greater. A pair of corresponding signal lines 20 can be shifted from each other to use as the single-end application. In this case, as shown in Fig. 5, there is the air layer between the two signal lines 20.

### Third Embodiment:

In the first and second embodiments, the signal lines forming the signal layers are held on both the sides of the support member of a dielectric material or the connection member of the support member, and the ground plates forming the ground layers are provided outside the signal layers. In the third embodiment, the ground plate is provided in the center and the signal layers are provided on both the sides of the ground plate.

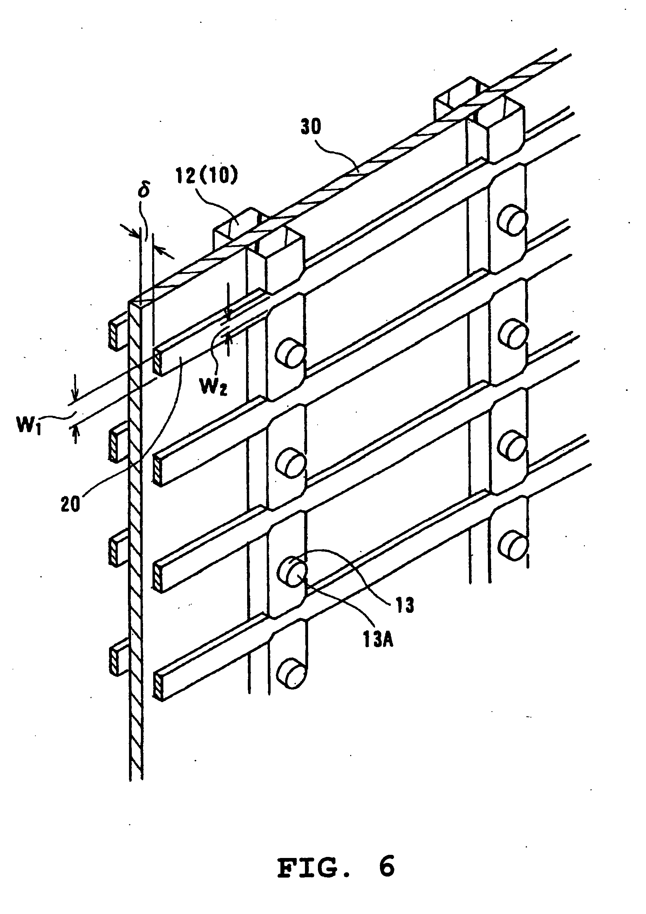

In Fig. 6, the ground plate 30 is supported in the center between a plurality of the connection members 12 extending in the vertical direction. The respective signal lines 20 forming two signal layers are supported on the outer side of the connection members 12. Each of the signal lines 20 is spaced from the ground plate 30 by a distance δ . The signal line 20 has a width W₁ in the range of the air layer and a width W₂ in the range supported by the connection members 12, wherein the width W₁ is greater than the width W₂. The dimensions of the widths W1 and W2 are determined such that the characteristic impedances in the two ranges are equal to each other.

In the third embodiment, the projections 13 of the connection members 12 can be omitted. However, the projections 13 may provided to prevent the signal lines 20 from touching other members when the board is accommodated in or fixed to the members.

### Fourth Embodiment:

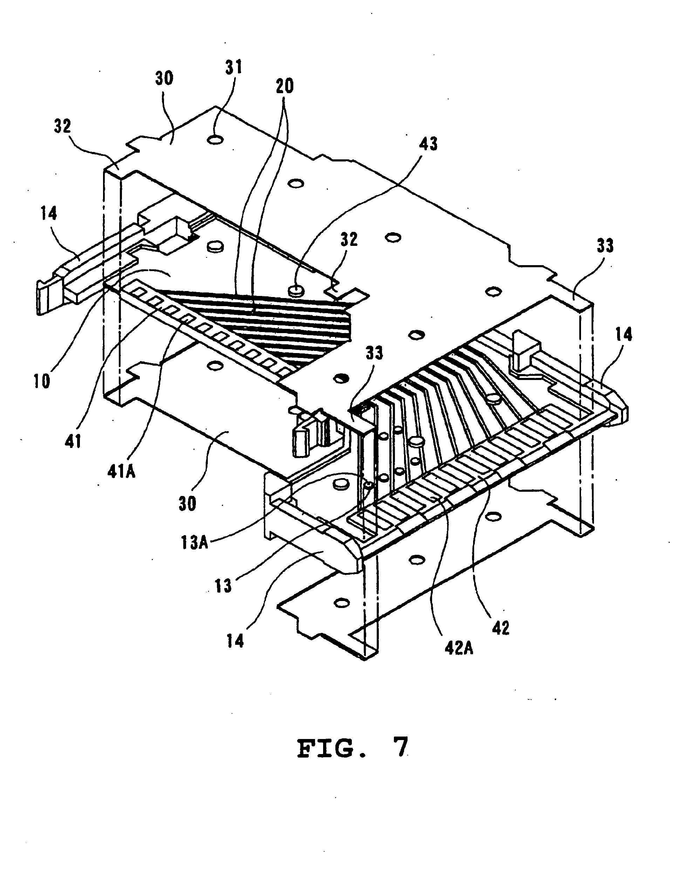

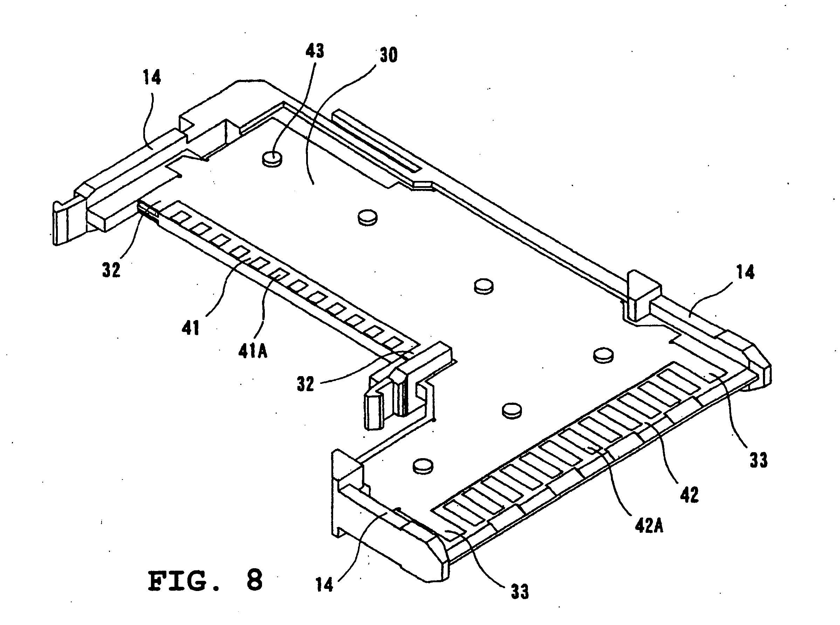

In the fourth embodiment, an example, in which the board structure described in the first to third embodiments is incarnated to a transmission circuit board, is described. In Fig. 7, separate materials or members are shown, while in Fig. 8, the separate members are assembled to a board. The same reference numerals are used for the same or similar members used in Figs. 1-6.

In Fig. 7, the flat support member 10 of a dielectric material comprises connection portions 41 and 42 provided at two edge portions on both sides thereof and having a larger thickness. Contact lands 41A and 42A are arranged in the connection portions 41 and 42. A plurality of signal lines 20 are arranged side by side and form curved paths on the surfaces of both the sides of the support member 10. The signal lines 20 are brought into electrical contact with the contact lands 41A and 42A in the connection portions 41 and 42.

A plurality of the projections 13 with the abutting faces 13A are provided in the support member 10 between the adjacent signal lines 20. A plurality of plug-in projections 43 having a height larger than that of the projections 13 are provided in the support member 10 at suitable positions. Some of the plug-in projections 43 are hung over the signal lines 20 to increase the support strength for the signal lines 20. The support member 10 has various flange portions 14 at the peripheries of the board to reinforce the board and connect the board to other similar board. The flange portions 14 are plugged in retainers (connection members), not shown, to hold a plurality of boards, thereby to assemble a connector apparatus.

The ground plates 30 are installed on both the sides of the support member 10. The ground plates 30 have an outline, which stays inside the various flange portions 14. Also, the ground plates 30 have holes 31, which are plugged in the plug-in projections 43 of the support member 10. Further, the ground plates 30 have terminal portions 32 and 33, which adjoin to the ends of the rows of the contact lands 41A and 42A of the connection portions 41 and 42.

In Fig. 8, the ground plates 30 are fixed to the support member 10. That is, the plug-in projections 43 of the support member 10 are plugged in the holes 31 of the ground plates 30 and integrally formed to provide the board. If the plug-in projections 43 and the holes 31 are fastened together by a screw-type fastener, no other fixing member is necessary. The ground plates 30 abut against the abutting faces 13A of the projections 13 and are spaced from the signal lines 20 by a constant distance everywhere. If any abutting member is provided along the inside of the flange portion 14, it is not necessary to provide the projections 13 between the signal lines 20.

A plurality of such boards are held by a retainer (not shown) to provide an intermediate connector. The connection portions 41 and 42 at the two edge portions of the board unable the connection with two apparatuses. The present invention is not limited to the embodiments and various variations are possible. For example, the support member and the connection members may be separate instead of being made integrally. The connection members may be formed integrally with the ground plates such that when the connection members abut against the support member, the ground plates are spaced from the signal lines. Also, separate connection members may be provided between the ground plates and the support members. Further, the connection members may be installed to the edge portion of the support member.

## Claims

1. A transmission circuit board structure comprising:
at least one signal layer formed by a plurality of signal lines arranged side by side;
at least one ground layer formed by a ground plate made of a sheet metal and extending up to a range of and in parallel to said signal layer; and
a support member made of a dielectric material, formed integrally with said signal lines to support said signal lines, and having at least one connection member, which abuts against said ground plate at a position where an insulation layer made by an air space is produced between said signal lines and said ground plate.

2. The transmission circuit board structure according to claim 1, wherein said connection member has a plurality of projections, which abut against said ground plate.

3. The transmission circuit board structure according to claim 1, wherein said projections have abutting faces on tops thereof, said abutting faces being provided on a flat plane and abutting against said ground plate.

4. The transmission circuit board structure according to claim 1, wherein each of said signal lines is formed of an elongated piece made of a thin sheet metal, which is in parallel to said ground plate.

5. The transmission circuit board structure according to claim 1, wherein said at least one signal layer and said at least one ground layer include a plurality of signal and ground layers, respectively, each of said signal and ground layers being provided reciprocally.

6. The transmission circuit board structure according to claim 1, wherein said connection member extends in a direction perpendicular to said plurality of said signal lines in the same signal layer.

7. The transmission circuit board structure according to claim 1, wherein said support member is positioned at a center of said transmission circuit board structure in a thicknesswise direction of said transmission circuit board structure and said signal and ground layers are symmetrically provided in this order on both sides of said support member in said thicknesswise direction.

8. The transmission circuit board structure according to claim 1, wherein said support member extends only in an area of said connection member and adjacent two layers of said signal layers provide said insulation layer of said air space therebetween in whole area other than said area of said connection member.

9. The transmission circuit board structure according to claim 1, wherein said support member supports said ground plate at a center of said transmission circuit board structure in a thicknesswise direction of said transmission circuit board structure and holds said signal lines on both outsides of said ground plate such that said air space is provided between said signal lines and said ground plate.

10. The transmission circuit board structure according to claim 5, wherein corresponding two of said signal lines, one each provided in either of two of said adjacent signal layers, make a pair.

11. The transmission circuit board structure according to claim 10, wherein said two corresponding signal lines making said pair are located at the same position when seen in a thicknesswise direction of said transmission circuit board structure.

12. The transmission circuit board structure according to claim 10, wherein said two corresponding signal lines making said pair are located at shifted positions when seen in a thicknesswise direction of said transmission circuit board structure.

13. The transmission circuit board structure according to claim 8, wherein each of said signal line has a first width in a first range where said each of said signal lines is supported by said support member and a second width in a second range where said air space exists between said adjacent signal layers, said first width being set smaller than said second width such that characteristic impedances in said first and second ranges become equal to each other.

14. A transmission circuit board comprising:
at least one signal layer formed by a plurality of signal lines arranged side by side;
at least one ground layer formed by a ground plate made of a sheet metal and extending in an area of and in parallel to said signal layer; and
a support member made of a dielectric material, formed integrally with said signal lines to support said signal lines, and having at least one connection member, which abuts against said ground plate at a position where an insulation layer made by an air space is produced between said signal lines and said ground plate, and at least one connection portion provided on a surface thereof along a verge thereof, wherein said signal line and said ground plate are brought into electrical contact with said connection portion.

15. A transmission circuit board connector comprising a plurality of transmission circuit boards held in parallel to each other by a retainer at a predetermined interval, each of said transmission circuit boards including:
at least one signal layer formed by a plurality of signal lines arranged side by side;
at least one ground layer formed by a ground plate made of a sheet metal and extending in an area of and in parallel to said signal layer; and
a support member made of a dielectric material, formed integrally with said signal lines to support said signal lines, and having at least one connection member, which abuts against said ground plate at a position where an insulation layer made by an air space is produced between said signal lines and said ground plate, and at least one connection portion provided on a surface of thereof along a verge thereof, wherein said signal line and said ground plate are brought into electrical contact with said connection portion.
